**Europäisches Patentamt**

**European Patent Office**

**Office européen des brevets**

(19)

(11) Veröffentlichungsnummer: **0 042 920**
**B1**

(12)    EUROPÄISCHE PATENTSCHRIFT

(45) Veröffentlichungstag der Patentschrift:
24.07.85

(21) Anmeldenummer: 81102685.5

(22) Anmeldetag: 09.04.81

(51) Int. Cl.⁴: **H 05 K  3/00**, H 05 K  3/24,
G 02 F  1/133

(54) **Verfahren zur Herstellung von auf einem Träger aufgebrachten Leiterbahnen.**

(30) Priorität: 27.06.80 DE 3024213

(43) Veröffentlichungstag der Anmeldung:
06.01.82 Patentblatt 82/1

(45) Bekanntmachung des Hinweises auf die Patenterteilung:
24.07.85 Patentblatt 85/30

(84) Benannte Vertragsstaaten:
CH FR GB IT LI NL SE

(56) Entgegenhaltungen:
DE - A - 1 223 910
GB - A - 980 715
GB - A - 2 051 449

(73) Patentinhaber: VDO Adolf Schindling AG,
Gräfstrasse 103, D-6000 Frankfurt/Main (DE)

(72) Erfinder: Faust, Wolfgang, Gartenstrasse 19,
D-6238 Hofheim (DE)
Erfinder: Nickol, Friedrich Wilhelm, Am Honigbaum 35,
D-6239 Eppstein 4 (DE)
Erfinder: Baeger, Holm, Dr., Salzbornstrasse 1,
D-6231 Schwalbach (DE)

(74) Vertreter: Könekamp, Herbert, Dipl.-Ing., Sodener
Strasse 9, D-6231 Schwalbach (DE)

## Beschreibung

Die Erfindung bezieht sich auf ein Verfahren zur Herstellung von auf einen Träger aufgebrachten Leiterbahnen, wobei eine Maske mit den Leiterbahnen entsprechenden Ausnehmungen auf den Träger aufgelegt wird und entsprechend den Aussparungen eine Leiterschicht von elektrisch leitendem Material auf den Träger aufgebracht wird.

Aus der GB-A-980 715 ist ein Verfahren bekannt, wobei unter Verwendung einer dünnen Maske Leiterbahnen auf einem Träger aufgebracht werden und wobei zur mechanischen Stabilisierung der dünnen Maske eine zweite dickere Maske auf die dünne Maske gelegt wird, die dickere Maske mit grösseren Ausnehmungen entsprechend den Leiterbahnen versehen ist, wobei jedoch die dünnere Maske die Dimensionen der Leiterbahnen bestimmt.

Bei dem Aufbringen von Leiterbahnen auf einen Träger mittels einer Maske kommt es bei kompliziert, mit vielen Ausnehmungen versehenen Masken zu dem Problem, dass die Maske so instabil ist, dass sie selbst, wenn sie auf einer ebenen Fläche aufliegt, nicht in ihrer gewünschten Form bleibt und die einzelnen Maskenteile sich gegeneinander verschieben. Es kann dabei sogar dazu kommen, dass Maskenteile sich so weit gegeneinander verschieben, dass es zu einer zumindest teilweisen Überdeckung von an sich getrennten Ausnehmungen und damit beim Auftragen der elektrisch leitenden Leiterschicht zu einem Kontakt zwischen eigentlich getrennt herzustellenden Leiterbahnen kommt. Gleichfalls kann es durch eine solche Verschiebung dazu kommen, dass durch die Überdeckung von einem Maskenteil eine an sich durchgehende Leiterbahn getrennt wird. Die Gefahr, die zu derartigen Problemen führt, ist insbesondere dann gross, wenn ein innerer Bereich von Leiterbahnen durch eine oder mehrere zueinander parallel verlaufende Ringleitungen weitgehend umschlossen ist. Dadurch besitzt die Maske keine selbsttragende mechanische Stabilität.

Besonders gross ist die Gefahr bei geschlossenen Ringleiterbahnen, da sich hierbei voneinander separate Maskenteile ergeben.

Diese Probleme sind z.B. bei Flüssigkristallanzeigen vorhanden, bei denen die einzelnen Versorgungsleitungen die zu den im Randbereich der Elektrodenträger angeordneten integrierten Schalteinheiten führen, als parallel dicht nebeneinander laufende Ringleitungen ausgebildet sind.

Es ist daher Aufgabe der Erfindung ein Verfahren nach dem Oberbegriff zu schaffen, durch das auf einfache Weise ein korrektes Auftragen der Leiterbahnen auf den Träger gewährleistet ist.

Diese Aufgabe wird erfindungsgemäss dadurch gelöst, dass die Aussparungen an bestimmten Stellen durch Stützstege derart unterbrochen sind, dass die Maske in ihrer Ebene eine mechanisch stabile Form erhält, und dass die durch die Stützstege beim Aufbringen der Leiterschicht elektrisch leitenden Materials hervorgerufenen Unterbrechungen der Leiterbahnen in einem zweiten Arbeitsgang durch das Aufbringen von elektrisch leitendem Material überbrückt werden. Durch die Stützstege wird zum einen erreicht, dass Masken, obwohl ihre Fläche weitgehend mit dicht nebeneinander und kompliziert verlaufenden Ausnehmungen versehen sind, trotzdem eine völlig stabile, nicht veränderbare Kontur beibehalten, wenn sie auf den Träger aufgelegt werden.

Zum anderen wird eine absolut korrekte Lage von durch eine geschlossene Ringausnehmung umschlossenen Maskeninnenteilen erreicht.

In einer vorteilhaften Ausbildung der Erfindung wird im ersten Arbeitsgang die Maske mit den die Leiterbahnen entsprechenden Aussparungen entfernt und eine Maske mit Aussparungen an den Stellen der Unterbrechungen der Leiterbahnen auf den Träger aufgelegt und eine Schicht elektrisch leitenden Materials aufgebracht. Somit werden die im ersten Arbeitsgang entstandenen Unterbrechungen der Leiterbahnen auf einfache Weise überbrückt. Wird dieses Verfahren bei Flüssigkristallanzeigen angewandt, so können die überbrückten Unterbrechungen sich auch im Bereich innerhalb der Flüssigkristallzelle befinden, da die Höhe dieser Überbrückungsstelle niedriger ist, als die Höhe des Innenraums der Flüssigkristallzelle. Ein Kurzschluss von der Elektrode mit den Überbrückungsstellen zur zweiten Elektrode an der anderen Seitenwand der Flüssigkristallzelle ist nicht möglich.

Wurde im ersten Arbeitsgang eine nicht lötfähige Leitschicht elektrisch leitfähigen Materials auf den Träger aufgebracht, wie dies bei Flüssigkristallanzeigen der Fall ist, so kann im zweiten Arbeitsgang auf die Maske eine die Bereiche der Leiterbahnen zu beiden Seiten der Stützstege offen lassende Abdeckung gelegt und eine Schicht lötfähigen Materials aufgebracht werden, wobei nach Abnahme von Maske und Abdeckung die Unterbrechungen durch Löten elektrisch leitend miteinander verbunden werden. Werden dabei an die Leiterbahnen die Anschlüsse von ein oder mehreren integrierten Schaltungseinheiten angeschlossen, so ist es vorteilhaft, wenn die Abdeckung die Bereiche der Leiterbahnen, an die die Anschlüsse der integrierten Schaltungseinheiten anschliessbar sind, offen lässt und wenn nach dem zweiten Arbeitsgang die integrierten Schaltungseinheiten auf den Träger aufgebracht und deren Anschlüsse durch Löten mit den jeweils zugeordneten Leiterbahnen elektrisch leitend verbunden werden. Auch diese Art des Herstellungsverfahrens lässt sich auf einfache Art und Weise durchführen.

Vorzugsweise wird die Leiterschicht mittels Aufdampfen oder Sputtern auf den Träger aufgebracht.

Der Träger kann ein Elektrodenträger einer Flüssigkristallanzeige sein.

Sind zwei im Abstand voneinander angeordnete Elektrodenträger einer Flüssigkristallanzeige vorhanden, auf denen sich gegenüberliegende, einander zugeordnete Elektroden angeordnet sind, die beim Zusammenbau der mit den Leiterbahnen versehenen Elektrodenträger an einem Kontaktpunkt elektrisch leitend miteinander verbunden werden, so können die Unterbrechungen der Leiterbahnen an den Stellen des Kontaktpunkts plaziert und der Kontaktpunkt durch das Auftragen von leitfähigem Material in einer dem Abstand der Elektrodenträger entsprechende Dicke hergestellt werden. Vorteilhafterweise besteht dabei der Kontaktpunkt aus einem elektrisch leitenden Kleber.

Auch bei diesem Verfahrensbeispiel werden zwei Funktionen in einem Arbeitsgang erfüllt, nämlich sowohl die elektrisch leitende Verbindung zwischen den Elektroden als auch die Überbrückung der Unterbrechungen der Leiterbahn hergestellt.

Bei durch zwei im Abstand zueinander angeordneten und zwischen sich eine Kammer bildenden Glasplatten einer Flüssigkristallanzeige, deren Innenseiten mit den Leiterbahnen versehen sind und die die Elektrodenträger bilden, wobei die Kammer eine Einfüllöffnung zum Einfüllen der Flüssigkristallsubstanz besitzt, die nach dem Füllvorgang verschlossen wird, können vorteilhafterweise die Unterbrechungen der Leiterbahnen an der Stelle der Einfüllöffnung plaziert und durch einen Füllöffnungsverschluss aus elektrisch leitendem Material überbrückt werden. Auch bei diesem Verfahren werden mit dem Verschliessen der Einfüllöffnung und dem Überbrücken der Unterbrechungen der Leiterbahnen in einem Arbeitsgang zwei Funktionen erfüllt.

Bei den Herstellungsverfahren, mit durch zwei im Abstand zueinander angeordneten und zwischen sich eine Kammer bildenden Glasplatten einer Flüssigkristallanzeige die in ein Gehäuse einbaubar ist, wobei der Bereich der Kammer durch ein Fenster des Gehäuses sichtbar und der Randbereich der die Elektrodenträger bildenden Glasplatten abgedeckt ist, ist es von Vorteil, wenn die integrierten Schaltungen und/oder die Unterbrechungen im abgedeckten Randbereich der Elektrodenträger angeordnet werden. Dadurch ist es nicht störend, wenn die Überbrückungen wie z.B. beim Löten durch eine sichtbare Verbindung hergestellt werden, da im Sichtbereich des Beobachters die Leiterbahnen aus transparentem Material sein können. Dieser Randbereich bleibt nach dem Zusammenbau der Flüssigkristallzelle offen, so dass die Chips der integrierten Schaltungen sowie die Lötarbeiten ungehindert durchgeführt werden können. Auch entstehen keine Probleme aufgrund der im Vergleich zu der geringen Höhe der Flüssigkristallkammer relativ grossen Dicke der Chips und der Lötverbindungen.

Ausführungsbeispiele der Erfindung sind in der Zeichnung dargestellt und im folgenden näher beschrieben. Es zeigen

Figur 1 einen Elektrodenträger für eine Flüssigkristallanzeige in zwei Arbeitsgängen mit vollständig aufgebrachten Leiterbahnen

Figur 2 den Elektrodenträger nach Figur 1 mit den im ersten Arbeitsgang aufgebrachten Leiterbahnen

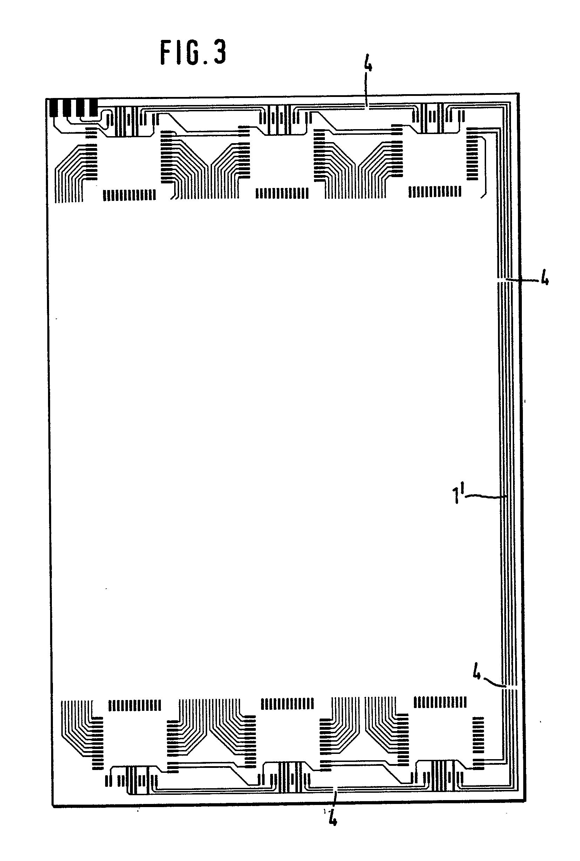

Figur 3 den Elektrodenträger nach Figur 1 mit den im zweiten Arbeitsgang aufgebrachten Leiterbahnen

Figur 4 einen Elektrodenträger für eine Flüssigkristallanzeige mit vollständig aufgebrachten Leiterbahnen, die durch Löten zu überbrückende Unterbrechungen aufweisen.

Die in den Figuren dargestellten Elektrodenträger sind mit den Leiterbahnen 1, 1' versehen, die zu den Elektroden 2, 2' führen. Dabei bilden die Elektroden 2 eine kreisförmige Geschwindigkeitsanzeige, während die Elektroden 2' einen Kilometerzähler bilden.

Die Elektroden 2 und 2' sind über die Leiterbahnen 1 mit im Randbereich des Elektrodenträgers angeordneten, als Chips ausgebildeten integrierten Schaltungen 3 verbunden.

Die Leiterbahnen 1' bilden Ringleitungen, die am Rand des Elektrodenträgers verlaufen und die Versorgungsleitungen der integrierten Schaltungen 3 sind. Diese Leiterbahnen 1' verlaufen etwa ein «U» bildend an drei Seiten des rechteckigen Elektrodenträgers entlang.

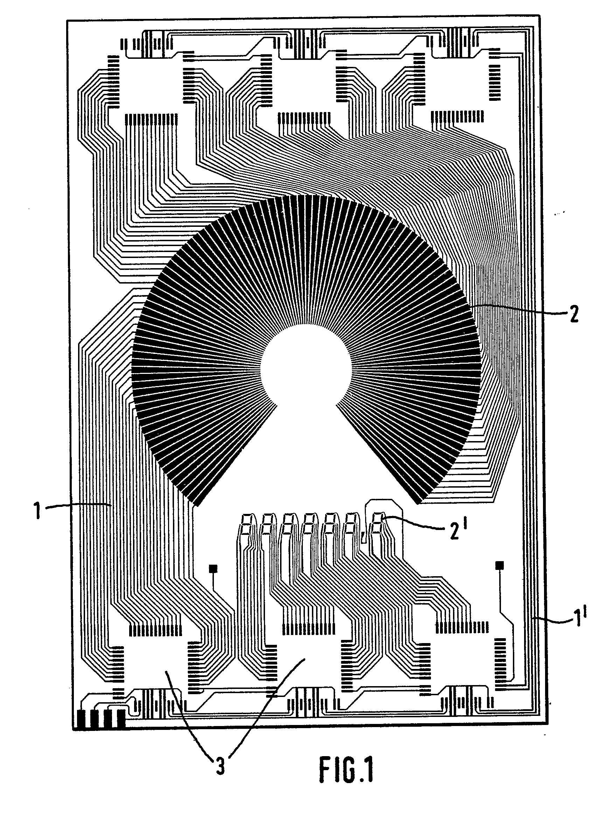

Ein Verfahren zur Herstellung eines Elektrodenträgers, wie er in Figur 1 dargestellt ist, erfolgt auf folgende Art und Weise:

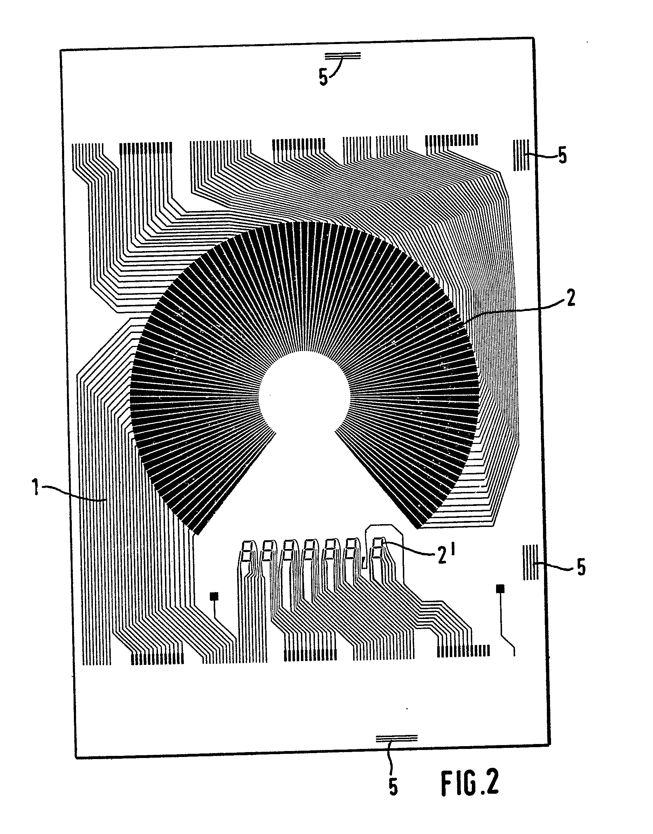

Zuerst wird auf den Elektrodenträger eine Maske aufgelegt, deren Ausnehmungen der Struktur der Leiterbahnen 1 und der Elektroden 2, 2', wie sie in Figur 2 dargestellt sind entsprechen. Z.B. durch Aufdampfen eines transparenten, leitfähigen Materials in einer Vakuumkammer werden dann die in Figur 2 dargestellten Leiterbahnen 1 sowie der Elektroden 2, 2' auf den Elektrodenträger aufgebracht.

Anschliessend wird die Maske wieder abgenommen und eine zweite Maske auf den Elektrodenträger aufgelegt, deren Ausnehmungen die Struktur der Leiterbahnen 1' besitzen. Ebenfalls durch Aufdampfen in einer Vakuumkammer werden nun die Leiterbahnen 1' auf den Elektrodenträger aufgebracht. Bei diesem zweiten Arbeitsgang wird aber ein lötfähiger Werkstoff aufgedampft, damit später die Anschlüsse der auf den Elektrodenträger aufgebrachten Chips der integrierten Schaltungen mit den ihnen zugeordneten Leiterbahnen 1' durch Löten verbunden werden können. Damit die einzelnen Teile der Maske zum Aufbringen der Leiterbahnen 1' durch deren U-förmigen Aufbau in ihrer Form nicht instabil werden sondern selbsttragend mechanisch stabil in ihrer Ebene bleiben, sind die Aussparungen der Maske an mehreren Stellen durch Stützstege unterbrochen, die bei den aufgetragenen Leiterbahnen 1' zu Unterbrechungen 4 führen.

Da aber an diesen Stellen, an denen die Leiterbahnen 1' in diesem Arbeitsgang unterbrochen sind, bereits im ersten Arbeitsgang mit den Leiterbahnen 1 zusammen Überbrückungsbahnen 5 auf den Elektrodenträger aufgebracht wurden, sind die Unterbrechungen 4 überbrückt. Probleme, die durch eine instabile Form der Maske für die Leiterbahnen 1' hervorgerufen werden könnten, werden durch die Stützstege bei der zweiten Maske vermieden.

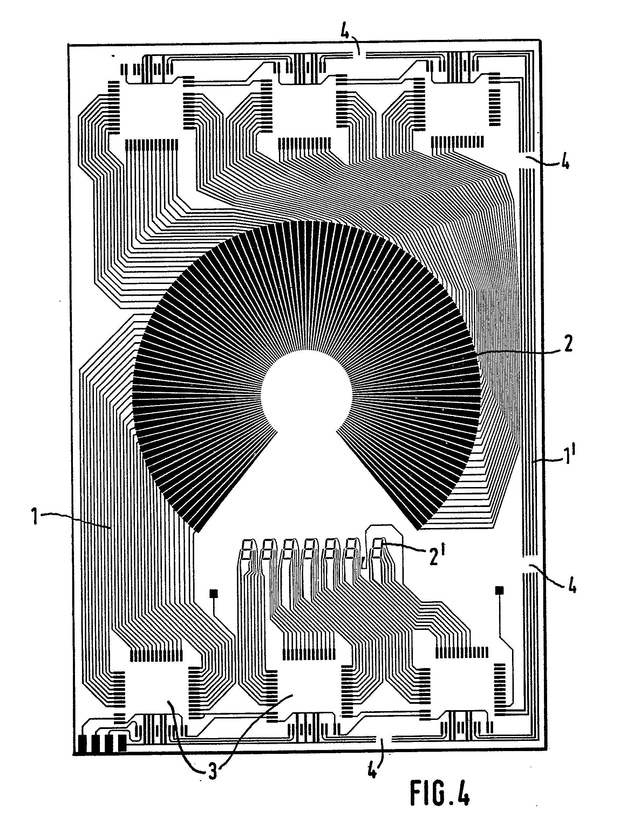

Eine zweite erfindungsgemässe Möglichkeit zur Herstellung des in Figur 1 dargestellten Elektrodenträgers besteht darin, dass auf den Elektrodenträger eine Maske aufgelegt wird, die Aussparungen entsprechend den in Figur 4 dargestellten Leiterbahnen 1, 1' sowie der Elektroden 2, 2' besitzt. Um die Form der Leiterbahnen 1' stabil zu halten, weist die Maske an verschiedenen Stellen Stützstege auf, die bei den Leiterbahnen 1' dann zu Unterbrechungen 4 führen. Auch bei diesem Verfahren werden in einem ersten Arbeitsgang durch z.B. Aufdampfen von transparentem, elektrisch leitendem Material in einer Vakuumkammer die Leiterbahnen 1 und 1' und die Elektroden 2, 2' auf den Elektrodenträger aufgebracht.

Diese erste Maske bleibt für den nächsten Arbeitsgang auf dem Elektrodenträger aufgelegt. Zusätzlich wird nun noch eine Abdeckung auf die Maske aufgelegt, so dass nur noch die Leiterbahnen 1' im Randbereich des Elektrodenträgers zu sehen sind.

Ebenfalls in einem Aufdampfvorgang wird nun eine Schicht aus lötfähigem, elektrisch leitendem Material auf die bereits vorhandenen Leiterbahnen 1' aufgebracht.

Nach Abnehmen der Abdeckung und der Maske können nun die Unterbrechungen 4 durch Löten überbrückt werden. Gleichzeitig kann man auch die jetzt in Form von Chips auf den Elektrodenträger aufgebrachten integrierten Schaltungen 3 mit ihren Anschlussleitungen durch Löten an die entsprechend zugeordneten Leiterbahnen 1 anschliessen.

Bei dem Einbau der nach o.g. Verfahren hergestellten Elektrodenträgern in Flüssigkristallanzeigen wird vorzugsweise so vorgegangen, dass bis auf das Aufbringen der integrierten Schaltungen 3 und der Lötarbeiten die Elektrodenträger mit den Leiterbahnen 1 und 1' fertiggestellt werden. Anschliessend werden die als Glasplatten ausgebildeten Elektrodenträger zu einer Zelle zusammengefügt, mit Flüssigkristallsubstanz gefüllt und verschlossen. Da der Elektrodenträger, auf dem die Leiterbahnen 1' angeordnet sind, grösser ist als der andere Elektrodenträger, bleiben die Leiterbahnen 1' ausserhalb der Zelle, so dass nun die integrierten Schaltungen aufgebracht und die Lötarbeiten an den Unterbrechungen 4 und an den Verbindungen der Leiterbahnen 1' mit den entsprechenden Kontakten der integrierten Schaltungen durchgeführt werden können. Die Verwendung unterschiedlicher Materialien für die Leiterbahnen 1 und 1' ist dadurch bedingt, dass die Leiterbahnen 1 für eine Flüssigkristallanzeige transparent sein und die Leiterbahnen 1' lötfähig sein sollten, wobei der Werkstoff für die Leiterbahnen 1 aber nicht lötfähig und der Werkstoff für die Leiterbahnen 1' aber nicht transparent ist. Da die Leiterbahnen 1' aber nicht im Sichtbereich des Betrachters der Flüssigkristallanzeige ist, brauchen sie auch nicht transparent zu sein.

**Patentansprüche**

1. Verfahren zur Herstellung von auf einen Träger aufgebrachten Leiterbahnen, wobei eine Maske mit den Leiterbahnen entsprechenden Ausnehmungen auf den Träger aufgelegt wird und entsprechend den Aussparungen eine Leiterschicht von elektrisch leitendem Material auf den Träger aufgebracht wird, dadurch gekennzeichnet, dass die Aussparungen an bestimmten Stellen durch Stützstege derart unterbrochen sind, dass die Maske in ihrer Ebene eine mechanisch stabile Form erhält, und dass die durch die Stützstege beim Aufbringen der Leiterschicht elektrisch leitenden Materials hervorgerufenen Unterbrechungen (4) der Leiterbahnen (1') in einem zweiten Arbeitsgang durch das Aufbringen von elektrisch leitendem Material überbrückt werden.

2. Verfahren nach Anspruch 1, dadurch gekennzeichnet, dass im zweiten Arbeitsgang die Maske mit den den Leiterbahnen (1, 1') entsprechenden Aussparungen entfernt und eine Maske mit Aussparungen an den Stellen der Unterbrechungen (4) der Leiterbahnen (1') auf den Träger aufgelegt und eine Schicht elektrisch leitenden Materials aufgebracht wird.

3. Verfahren nach Anspruch 1, bei dem im ersten Arbeitsgang eine nicht lötfähige Leiterschicht elektrisch leitfähigen Materials aufgebracht wurde, dadurch gekennzeichnet, dass im zweiten Arbeitsgang auf die Maske eine die Bereiche der Leiterbahnen (1') zu beiden Seiten der Stützstege offen lassende Abdeckung gelegt und eine Schicht lötfähigen Materials aufgebracht wird, und dass nach Abnahme von Maske und Abdeckung die Unterbrechungen (4) durch Löten elektrisch leitend miteinander verbunden werden.

4. Verfahren nach Anspruch 3, bei dem an die Leiterbahnen die Anschlüsse von ein oder mehreren integrierten Schaltungseinheiten angeschlossen werden, dadurch gekennzeichnet, dass die Abdeckung die Bereiche der Leiterbahnen (1'), an die die Anschlüsse der integrierten Schaltungseinheiten (3) anschliessbar sind, offen lässt, und dass nach dem zweiten Arbeitsgang die integrierten Schaltungseinheiten (3) auf den Träger aufgebracht und deren Anschlüsse durch Löten mit den jeweils zugeordneten Leiterbahnen (1') elektrisch leitend verbunden werden.

5. Verfahren nach einem der vorhergehenden Ansprüche, dadurch gekennzeichnet, dass die Leiterschicht mittels Aufdampfen oder Sputtern auf den Träger aufgebracht wird.

6. Verfahren nach einem der vorhergehenden Ansprüche, dadurch gekennzeichnet, dass der Träger ein Elektrodenträger einer Flüssigkristallanzeige ist.

7. Verfahren nach Anspruch 6, mit zwei im Abstand voneinander angeordneten Elektrodenträgern einer Flüssigkristallanzeige, auf denen sich gegenüberliegende, einander zugeordnete Elektroden angeordnet sind, die beim Zusammenbau der mit den Leiterbahnen versehenen Elektrodenträger an einem Kontaktpunkt elektrisch leitend miteinander verbunden werden, dadurch gekennzeichnet, dass die Unterbrechungen der Leiterbahnen an den Stellen des Kontaktpunktes plaziert und der Kontaktpunkt durch das Auftragen von leitfähigem Material in einer dem Abstand der Elektrodenträger entsprechenden Dicke hergestellt werden.

8. Verfahren nach Anspruch 7, dadurch gekennzeichnet, dass der Kontaktpunkt aus einem elektrisch leitenden Kleber besteht.

9. Verfahren nach Anspruch 6, mit durch zwei im Abstand zueinander angeordneten und zwischen sich eine Kammer bildenden Glasplatten einer Flüssigkristallanzeige, deren Innenseiten mit den Leiterbahnen versehen sind und die die Elektrodenträger bilden, wobei die Kammer eine Einfüllöffnung zum Einfüllen der Flüssigkristallsubstanz besitzt, die nach dem Füllvorgang verschlossen wird, dadurch gekennzeichnet, dass die Unterbrechungen der Leiterbahnen an der Stelle der Einfüllöffnung plaziert und durch einen Füllöffnungsverschluss aus elektrisch leitendem Material überbrückt werden.

10. Verfahren nach einem der Ansprüche 6–9, mit durch zwei im Abstand zueinander angeordneten und zwischen sich eine Kammer bildenden Glasplatten einer Flüssigkristallanzeige, die in ein Gehäuse einbaubar ist, wobei der Bereich der Kammer durch ein Fenster des Gehäuses sichtbar und der Randbereich der die Elektrodenträger bildenden Glasplatten abgedeckt ist, dadurch gekennzeichnet, dass die integrierten Schaltungseinheiten (3) und/oder die Unterbrechungen (4) im abgedeckten Randbereich der Elektrodenträger angeordnet werden.


## Claims

1. Method for the production of conductor tracks arranged on a support, a mask with apertures corresponding to the tracks being placed on the support, and a conductor layer of electrically conductive material being applied to the support in accordance with the apertures, characterised in that the apertures are so interrupted by supporting webs at specific places that the mask is given a mechanically stable form in its plane, and that in a second operation the interruptions (4) in the tracks (1') produced by the supporting webs at the application of the conductor layer of electrically conductive material are bridged by the application of electrically conductive material.

2. Method according to claim 1, characterised in that in the second operation the mask with the apertures corresponding to the tracks (1, 1') is removed, and a mask with apertures at the places where the interruptions (4) of the tracks (1') are situated is placed on the support and a layer of electrically conductive material is applied.

3. Method according to claim 1, wherein a non-solderable conductor layer of electrically conductive material has been applied in the first operation, characterised in that in the second operation a cover leaving open the regions of the tracks (1') at the two sides of the supporting webs is placed on the mask, and a layer of solderable material is applied, and that after removal of mask and cover the interruptions (4) are electrically conductively connected to one another by soldering.

4. Method according to claim 3, wherein the terminals of one or more integrated circuit units are connected to the tracks, characterised in that the cover leaves open those regions of the tracks (1') to which the terminals of the integrated circuit units (3) are connectable, and that after the second operation the integrated circuit units (3) are put on to the support and their terminals are connected in electrically conductive manner to the respective associated tracks (1') by soldering.

5. Method according to one of the preceding claims, characterised in that the conductor layer is applied to the support by means of a vapour coating process or by sputtering.

6. Method according to one of the preceding claims, characterised in that the support is an electrode support of a liquid crystal display.

7. Method according to claim 6, with two electrode supports of a liquid crystal display which are situated spaced from one another and on which there are arranged mutually opposite electrodes associated with each other, the said electrodes being connected to one another in electrically conductive manner at a contact point at assembly of the electrode supports provided with the tracks, characterised in that the interruptions of the tracks are located at the contact point situations, and the contact point is produced by the application of conductive material to a thickness appropriate to the spacing of the electrode supports.

8. Method according to claim 7, characterised in that the contact point consists of an electrically conductive adhesive substance.

9. Method according to claim 6, with two glass plates of a liquid crystal display which are arranged spaced from each other and form a chamber between themselves, and whose inner sides are provided with the tracks, and which form the electrode supports, and the chamber comprises a filling opening through which the liquid crystal substance is introduced, said opening being closed after the filling operation, characterised in that the interruptions in the tracks are located at the place where the filling opening is situated, and are bridged by a filling opening seal made of electrically conductive material.

10. Method according to one of claims 6–9, with two glass plates, which are arranged spaced apart from one another and form a chamber between each other, of a liquid crystal display which can be incorporated in a housing, and the region of the chamber is visible through a housing window, and the edge region of the glass plates which form the electrode supports is covered, characterised in that the integrated circuit units (3) and/or the interruptions (4) are arranged in the covered edge region of the electrode supports.


## Revendications

1. Procédé de formation de pistes conductrices déposées sur un support, dans lequel on pose sur le support un masque présentant des parties ajourées qui correspondent à ces pistes et on dépose sur ce support, selon ces parties ajourées, une couche d'une matière électriquement conductrice, procédé caractérisé en ce que les parties ajourées sont interrompues à des endroits déterminés par des traverses de soutien, de façon que le masque garde dans son plan une forme mécaniquement stable et, dans une seconde opération, on ponte les zones de discontinuité (4) des pistes conductrices (1'), créées par ces traverses au cours de l'application de la couche conductrice, en déposant une matière électriquement conductrice.

2. Procédé selon la revendication 1, caractérisé en ce que, dans la seconde opération, on enlève le masque qui présente les parties ajourées correspondant aux pistes conductrices (1, 1'), on pose sur le support un masque présentant des parties ajourées à l'emplacement des zones de discontinuité (4) des pistes conductrices (1') et on dépose une couche de matière électriquement conductrice.

3. Procédé selon la revendication 1, dans lequel on a déposé dans la première opération une couche d'une matière électriquement conductrice non soudable, caractérisé en ce que, dans la seconde opération, on pose sur le masque un cache qui laisse apparentes les zones de ces pistes (1') situées des deux côtés des traverses de soutien et l'on applique une couche de matière soudable et, après avoir enlevé le cache et le masque, on ponte les zones de discontinuité (4) en en reliant électriquement les bords par soudure.

4. Procédé selon la revendication 3, dans lequel on connecte aux pistes conductrices les bornes d'un ou plusieurs circuits intégrés, procédé caractérisé en ce que le cache laisse découvertes les régions des pistes (1') auxquelles les bornes des circuits intégrés (3) doivent être connectées et, après la seconde opération, on place ces circuits intégrés (3) sur le support et on réalise par soudure la connexion électrique de leurs bornes avec les pistes conductrices (1') respectives.

5. Procédé selon l'une des revendications précédentes, caractérisé en ce que l'on dépose la couche conductrice sur le support par évaporation ou par pulvérisation.

6. Procédé selon l'une des revendications précédentes, caractérisé en ce que le support est un support d'électrodes d'un dispositif d'affichage à cristaux liquides.

7. Procédé selon la revendication 6, dans lequel deux supports d'électrodes d'un dispositif d'affichage à cristaux liquides sont disposés à une certaine distance l'un de l'autre et portent des électrodes qui se font vis-à-vis, qui coopèrent mutuellement et qui, lorsque ces supports d'électrodes présentent les pistes conductrices sont assemblés, sont connectées électriquement sur un point de contact, procédé caractérisé en ce que l'on forme les zones de discontinuité des pistes conductrices aux emplacements des points de contact et l'on forme ces derniers par dépôt d'une matière conductrice sur une épaisseur correspondant à la distance séparant les supports d'électrodes.

8. Procédé selon la revendication 7, caractérisé en ce que le point de contact est formé par un adhésif électriquement conducteur.

9. Procédé selon la revendication 6, dans lequel on dispose à une certaine distance l'une de l'autre deux plaques de verre d'un dispositif d'affichage à cristaux liquides qui forment entre elles une chambre, dont les faces intérieures portent les pistes conductrices et qui constituent les supports d'électrodes, la chambre présentant, pour l'introduction de la substance à cristaux liquides, une ouverture qui est obturée après le remplissage, procédé caractérisé en ce que l'on forme les zones de discontinuité des pistes conductrices à l'emplacement de cette ouverture et on les ponte au moyen d'un bouchon obturateur en une matière électriquement conductrice.

10. Procédé selon l'une des revendications 6 à 9, dans lequel on dispose à une certaine distance l'une de l'autre deux plaques de verre d'un dispositif d'affichage à cristaux liquides, qui forment entre elles une chambre et qui peuvent être montées dans un boîtier, l'emplacement de la chambre étant visible par une fenêtre de ce boîtier et la zone marginale de ces plaques, qui constituent les supports d'électrodes, étant opaque, procédé caractérisé en ce que l'on place les circuits intégrés (3) et/ou les zones de discontinuité (4) dans la zone marginale opaque de ces supports d'électrodes.

FIG.1

FIG.2

# FIG.3

FIG.4